# EUROPEAN PATENT APPLICATION

(11) **EP 3 800 230 A1**
(43) Date of publication of application: **07.04.2021**
(21) Application number: 20210169.7
(22) Date of filing: 18.01.2017
(51) Int. Cl.: C09K 11/02, A01G 7/04, A01G 9/14, C09K 11/68, H01L 33/50

(54) **A COMPOSITION, COLOR CONVERTING SHEET AND LIGHT EMITTING DIODE DEVICE**

(30) Priority: 26.01.2016 EP 16000178
(62) Divisional of application: 19163945.9
(71) Applicant: Merck Patent GmbH, 64293 Darmstadt (DE)
(72) Inventor: Okura, Hiroshi, TOKYO 153-8927 (JP); Dertinger, Stephan, 64293 DARMSTADT (DE); Nishihara, Eiji, TOTTORI 680-8550 (JP); Ishigaki, Tadashi, TOTTORI 680-8550 (JP); Ohmi, Koutoku, TOTTORI 680-8550 (JP)

(57) **Abstract**

The present invention relates to a composition comprising a fluorescent material and a matrix material.

## Description

### Field of the Invention

The present invention relates to a composition comprising a fluorescent material and a matrix material, a color conversion sheet and a light emitting diode device. The present invention further relates to the use of the composition in a color conversion sheet fabrication process, to the use of the color conversion sheet in optical devices or for agriculture purposes, and to the use of the fluorescent material and the matrix material in light emitting diode devices. Additionally, the invention relates to an optical device comprising the color conversion sheet and to a method for preparing the color conversion sheet and the optical device.

### Background Art

A color conversion sheet including a plurality of fluorescent materials, a light emitting diode device comprising a fluorescent material and optical devices comprising a light conversion sheet for agriculture are known in the prior arts, for example, as described in JP 2007-135583A, WO 1993/009664 A1, JP H09-249773A, JP 2001-28947A, JP 2004-113160A

### Patent Literature

1. JP 2007-135583A
2. WO 1993/009664 A1
3. JP H09-249773A
4. JP 2001-28947A
5. JP 2004-113160A

### Summary of the invention

However, the inventors surprisingly have found that there is still one or more considerable problems for which improvement are desired, as listed below.
1. A novel color conversion sheet which shows better UV stability, improved color fastness and color stability on color less, and less concentration quenching of a fluorescent materials is desired.
2. A novel color conversion sheet and / or a light emitting diode device comprising a fluorescent material and matrix material which shows better plant growth ability, is required.
3. A novel color conversion sheet and / or a light emitting diode device comprising a fluorescent material and matrix material, in which can absorb UV and / or purple light (430 nm or shorter wavelength) to keep off harmful insects from plants, is desired.
4. A novel color conversion sheet and / or a light emitting diode device comprising a fluorescent material and matrix material, in which can pass through blue light.

Surprisingly, the inventors have found a novel composition comprising at least one inorganic fluorescent material having the peak emission light wavelength in the range from 660 nm to 730 nm, and a matrix material, solves one or more of problems of 1 to 4. Preferably, it solves all the problems 1 to 4 at the same time.

In another aspect, the invention relates to a novel color conversion sheet (100) comprising at least one inorganic fluorescent material (110) having the peak emission light wavelength in the range from 660 nm to 730 nm, and a matrix material (120).

In another aspect, the invention relates to a novel light emitting diode device (200) comprising at least one inorganic fluorescent material (210) having the peak emission light wavelength in the range from 660 nm to 730 nm, a matrix material (220), and a light emitting diode element (230).

In another aspect, the invention relates to an optical device (300) comprising the color conversion sheet (301).

In another aspect, the invention relates to use of the composition in a color conversion sheet fabrication process.

In another aspect, the invention relates to use of the color conversion sheet (100) in an optical device or for agriculture.

In another aspect, the invention further relates to use of the inorganic fluorescent material having the peak emission light wavelength in the range from 660 nm to 730 nm with a matrix material in a light emitting diode device (200).

In another aspect, the present invention furthermore relates to method for preparing the color conversion sheet (100), wherein the method comprises following steps (a) and (b) in this sequence;
(a) providing the composition onto a substrate, and
(b) fixing the matrix material by evaporating a solvent and / or polymerizing the composition by heat treatment, or exposing the photosensitive composition under ray of light or a combination of any of these.

In another aspect, the present invention furthermore relates to method for preparing the optical device (200), wherein the method comprises following step (A);

### (A) providing the color conversion sheet (100) in an optical device

Further advantages of the present invention will become evident from the following detailed description.

### Description of drawings

Fig. 1: shows a cross sectional view of a schematic of one embodiment of a color conversion sheet (100).
Fig. 2: shows a cross sectional view of a schematic of one embodiment of a light emitting diode device (200) of the invention.
Fig. 3: shows a cross sectional view of a schematic of another embodiment of a light emitting diode device of the invention.
Fig. 4: shows results of working example 5.
Fig. 5: shows results of working example 5.

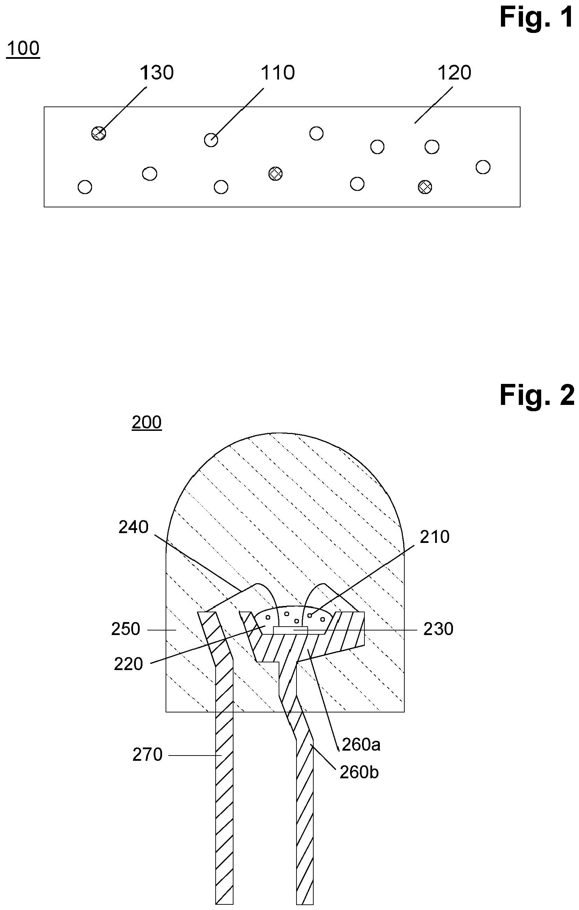

### List of reference signs in figure 1

100. a color conversion sheet
110. an inorganic fluorescent material of the invention
120. a matrix material
130. an another type of inorganic fluorescent material (optional)

### List of reference signs in figure 2

200. a light emitting diode device
210. an inorganic fluorescent material of the invention
220. a matrix material
230. a light emitting diode element
240. conductive wires
250. a molding Material
260a. a cup
260b. a mount lead
270. an inner lead

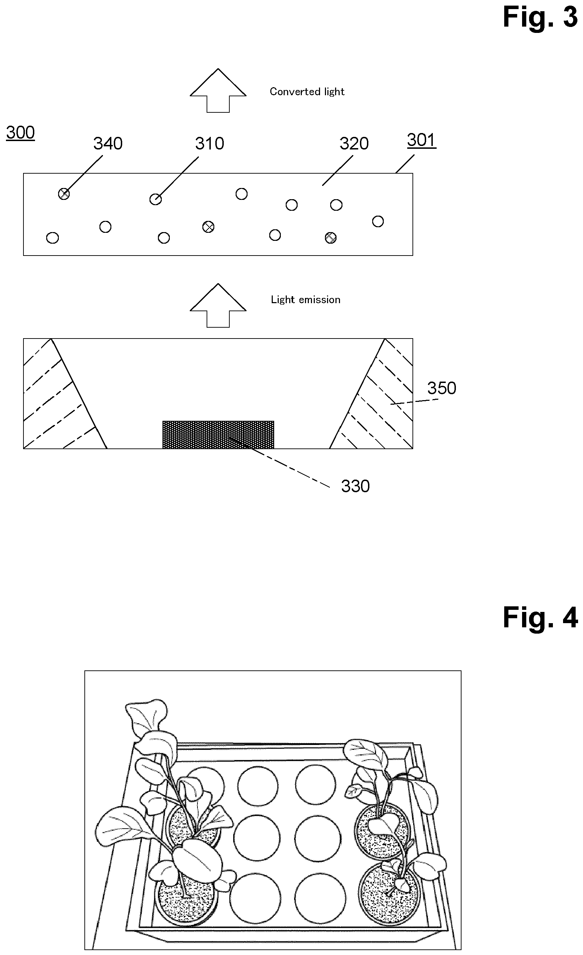

### List of reference signs in figure 3

300. a light emitting diode device
301. a color conversion sheet
310. an inorganic fluorescent material of the invention
320. a matrix material
330. a light emitting diode element
340. an another type of inorganic fluorescent material (optional)
350. a casing

### Detailed Description of the invention

According to the present invention, said composition comprising at least one inorganic fluorescent materials having the peak emission light wavelength in the range from 660 nm to 730 nm, and a matrix material, is provided by the inventors to solve all the problems 1 to 4 at the same time.

### - Inorganic fluorescent materials

According to the present invention, any type of publically known inorganic fluorescent materials having the peak emission light wavelength in the range from 660 nm to 730 nm, for example as described in the second chapter of Phosphor handbook (Yen, Shinoya, Yamamoto), can be used as desired.

In a preferred embodiment of the present invention, the inorganic fluorescent materials can emit a light having the peak emission light wavelength in the range from 670 nm to 700 nm

Without wishing to be bound by theory, it is believed that the inorganic fluorescent material having at least one light absorption peak wavelength in UV and / or purple light wavelength region from 300 nm to 430 nm may keep harmful insects off plants.

Therefore, even more preferably, the inorganic fluorescent material has at least one light absorption peak wavelength in UV and / or purple light wavelength reason from 300 nm to 430 nm.

Preferably, the inorganic fluorescent material is selected from the group consisting of sulfides, thiogallates, nitrides, oxy-nitrides, silicates, metal oxides, apatites, phosphates, selenides, botates, carbon materials, quantum sized materials and a combination of any of these.

In a preferred embodiment of the present invention, the inorganic fluorescent material is selected from the group consisting of Al₂O₃:Cr³⁺, Y₃Al₅O₁₂:Cr³⁺, MgO:Cr³⁺, ZnGa₂O₄: Cr³⁺, MgAl₂O₄: Cr³⁺,MgSr₃Si₂O₈:Eu²⁺,Mn²⁺, Mg₂SiO₄:Mn²⁺, BaMg₆Ti₆O₁₉:Mn⁴⁺, Mg₂TiO₄:Mn⁴⁺, ZnAl₂O₄:M²⁺, LiAlO₂:Fe³⁺, LiAl₅O₈: Fe³⁺, NaAlSiO₄: Fe³⁺, MgO: Fe³⁺, Mg₈Ge₂O₁₁F₂:Mn⁴⁺, CaGa₂S₄:Mn²⁺, Gd₃Ga₅O₁₂:Cr³⁺, Gd₃Ga₅O₁₂:Cr³⁺,Ce³⁺; quantum sized materials such as ZnS, InP/ZnS, InP/ZnSe, InP/ZnSe/ZnS, CuInS₂, CuInSe₂, CuInS₂/ZnS, carbon/graphen quantum dots and a combination of any of these.

Without wishing to be bound by theory, it is found by the inventors that the Cr activated metal oxide phosphors are very useful for plant growth, since it shows narrow full width at half maximum (hereafter "FWHM") of the light emission, and also have the peak absorption wavelength in UV and green wavelength region such as 420 nm and 560 nm, and the emission peak wavelength is in near infrared ray region such as from 660 nm to 730 nm. More preferably, it is from 670 nm to 700 nm.

In other words, without wishing to be bound by theory, it is believed that the inventors have found that the Cr activated metal oxide phosphors can absorb the specific UV light which attracts insects, and also green light which does not give any advantage for plant growth, and can convert the absorbed light to longer wavelength in the range from 660 nm to 730 nm, more preferably from 670 nm to 700 nm, which can effectively accelerate plant growth.

From that point of view, even more preferably, the inorganic fluorescent material can be selected from a Cr activated metal oxide phosphors.

In a further preferred embodiment of the present invention, the inorganic fluorescent material is selected from Cr activated metal oxide phosphors represented by following formulae (I) or (II)

AₓB_{y}O_{z}:Cr³⁺ - (I)

wherein A is a trivalent cation and is selected from the group consisting of Y, Gd, Lu, Ce, La, Tb, Sc, and Sm, B is a trivalent cation and is selected from the group consisting of Al, Ga, Lu, Sc, In; x ≧ 0; y ≧ 1; 1.5(x+y) = z;

XₐZ_{b}O_{c}:Cr³⁺ - (II)

wherein X is a divalent cation and is selected from the group consisting of Mg, Zn, Cu, Co, Ni, Fe, Ca, Sr, Ba, Mn, Ce and Sn; Y is a trivalent cation and is selected from the group consisting of Al, Ga, Lu, Sc and In; b ≧ 0; a ≧ 1; (a+1.5b) = c

Furthermore preferably, the inorganic fluorescent material is selected from Cr activated metal oxide phosphors represented by following formulae (I') or (II')

AₓB_{y}O_{z}:Cr³⁺ - (I')

wherein A is a trivalent cation and is selected from the group consisting of Y, Gd, and Zn, B is a trivalent cation and is Al or Ga; x ≧ 0; y ≧ 1; 1.5(x+y) = z;

XₐZ_{b}O_{c}:Cr³⁺ - (II')

wherein X is a divalent cation and is selected from the group consisting of Mg, Co, and Mn; Z is a trivalent cation and is selected from the group consisting of Al, or Ga; b ≧ 0; a ≧ 1; (a+1.5b) = c.

In a preferred embodiment of the present invention, x can be 0 or an integer 1 to 5, y is an integer 1 to 8.
More preferably, x can be 0 or an integer 1 to 3, y is an integer 1 to 5.

In a preferred embodiment of the present invention, the symbol "a" is an integer 1 to 3, "b" can be 0 or an integer 1 to 6.
More preferably, "a" can be an integer 1 to 2, "b" is 0 or an integer 2 to 4.

In a more preferred embodiment of the present invention, the inorganic fluorescent material is a Cr activated metal oxide phosphor selected from the group consisting of Al₂O₃:Cr³⁺, Y₃Al₅O₁₂:Cr³⁺, MgO:Cr³⁺, ZnGa₂O₄: Cr³⁺, MgAl₂O₄: Cr³⁺, and a combination of any of these.

### - Matrix materials

According to the present invention, as the matrix material, transparent photosetting polymer, a thermosetting polymer, a thermoplastic polymer, glass substrates or a combination of any of these, can be used preferably. As polymer materials, polyethylene, polypropylene, polystyrene, polymethylpentene, polybutene, butadiene styrene, polyvinyl chloride, polystyrene, polymethacrylic styrene, styrene-acrylonitrile, acrylonitrile-butadiene-styrene, polyethylene terephthalate, polymethyl methacrylate, polyphenylene ether, polyacrylonitrile, polyvinyl alcohl, acrylonitrile polycarbonate, polyvinylidene chloride, polycarbonate, polyamide, polyacetal, polybutylene terephthalate, polytetrafluoroethylene, phenole, melamine, urea, urethane, epoxy, unsaturated polyester, polyallyl sulfone, polyarylate, hydroxybenzoic acid polyester, polyetherimide, polycyclohexylenedimethylene terephthalate, polyethylene naphthalate, polyester carbonate, polylactic acid, phenolic resin, silicone can be used preferably.

As the photosetting polymer, several kinds of (meth)acrylates can be used preferably. Such as unsubstituted alkyl-(meth)acrylates, for examples, methyl-acrylate, methyl-methacrylate, ethyl-acrylate, ethyl-methacrylate, butyl-acrylate, butyl-methacrylate, 2-ethylhexyl-acrylate, 2-ethylhexyl-methacrylate; substituted alkyl-(meth)acrylates, for examples, hydroxyl-group, epoxy group, or halogen substituted alkyl-(meth)acrylates; cyclopentenyl(meth)acrylate, tetra-hydro furfuryl-(meth)acrylate, benzyl (meth)acrylate, polyethylene-glycol di-(meth)acrylates,

In view of better coating performance of the composition, sheet strength, and good handling, the matrix material has a weight average molecular weight in the range from 5,000 to 50,000 preferably, more preferably from 10,000 to 30,000.

According to the present invention, the molecular weight M_{w} can be determined by means of GPC (= gel permeation chromatography) against an internal polystyrene standard.

Additionally, the photosetting polymer can embrace one or more of publically available vinyl monomers that are co-polymerizable. Such as acrylamide, acetonitrile, diacetone-acrylamide, styrene, and vinyl-toluene or a combination of any of these.

According to the present invention, the photosetting polymer can further include one or more of publically available crosslinkable monomers. For example, cyclopentenyl(meth)acrylates; tetra-hydro furfuryl-(meth)acrylate; benzyl (meth)acrylate; the compounds obtained by reacting a polyhydric alcohol with and α,β-unsaturated carboxylic acid, such as polyethylene-glycol di-(meth)acrylates (ethylene numbers are 2-14), tri-methylol propane di(meth)acrylate, tri-methylol propane di (meth)acrylate, tri-methylol propane tri-(meth)acrylate, tri-methylol propane ethoxy tri-(meth) acrylate, tri-methylol propane propoxy tri-(metha) acrylate, tetra-methylol methan tri-(meth) acrylate), tetra-methylol methane tetra(metha) acrylate, polypropylene glycol di(metha)acrylates (propylene number therein are 2-14), Di-penta-erythritol penta(meth)acrylate, di-penta-erythritol hexa(meth)acrylate, bis-phenol-A Polyoxyethylene di-(meth)acrylate, bis-phenol-A dioxyethylene di-(meth)acrylate, bis-phenol-A trioxyethylene di-(meth)acrylate, bis-phenol-A decaoxyethylene di-(meth)acrylate; the compounds obtained from an addition of an α,β-unsaturated carboxylic acid to a compound having glycidyl, such as tri-methylol propane triglycidylether triacrylate, bis-phenol A diglycidylether diacrylates; chemicals having poly-carboxylic acids, such as a phtalic anhydride; or chemicals having hydroxy and ethylenic unsaturated group, such as the esters with β-hydroxyethyl (meth)acrylate; alkyl-ester of acrylic acid or methacylic acid, such as methyl (meth)acrylate, ethyl (meth)acrylate, butyl (meth)acrylate, 2-ethyl hexyl (meth)acrylate; urethane (meth)acrylate, such as the reactants of Tolylene diisocyanate and 2-hydroxyethyl (meth)acrylate, the reactants of tri-methyl hexamethylene diisocyanate and cyclohexane dimethanol, and 2-hydroxyethyl (meth)acrylate; or a combination of any of these.
In a preferred embodiment of the present invention, the crosslinkable monomer can be selected from the group consisting of tri-methylol-propane tri (meth)acrylate, di-pentaerythritol tetra-(meth)acrylate, di-pentaerythritol hexa-(meth)acrylate, bisphenol-A polyoxyethylene dimethacrylate or a combination thereof.

The vinyl monomers and the crosslinkable monomers described above can be used alone or in combination.

From the view point of controlling the refractive index of the composition and / or the refractive index of the color conversion sheet according to the present invention, the matrix material can further comprise publically known one or more of bromine-containing monomers, sulfur containing monomers. The type of bromine and sulfur atom-containing monomers (and polymers containing the same) are not particularly limited and can be used preferably as desired. For example, as bromine-containing monomers, new frontier® BR-31, new Frontier® BR-30, new Frontier® BR-42M (available from DAI-ICHI KOGYO SEIYAKU CO., LTD) or a combination of any of these, as the sulfur-containing monomer composition, IU-L2000, IU-L3000, IU-MS1010 (available from MITSUBISHI GAS CHEMICAL COMPANY, INC.) or a combination of any of these, can be used preferably.

According to the present invention, the photosetting polymer can preferably embrace at least one of photo initiator.
The type of photo initiator is not particularly limited. Publically known photo initiator can be used in this way.

In a preferred embodiment of the present invention, the photo initiator can be a photo initiator that can generates a free radical when it is exposed to an ultraviolet light or a visible light. For example, benzoin-methyl-ether, benzoin-ethyl-ether, benzoin-propyl-ether, benzoin-isobutyl-ether, benzoin-phenyl-ether, benzoin-ethers, benzophenone, N,N'-tetramethyl-4,4'-diaminobenzophenone (Michler's-ketone), N,N'-tetraethyl-4,4'diaminobenzophenone, benzophenones, benzil-dimethyl-ketal (Ciba specialty chemicals, IRGACURE® 651), benzil-diethyl-ketal, dibenzil ketals, 2,2-dimethoxy-2-phenylacetophenone, p-tert-butyldichloro acetophenone, p-dimethylamino acetophenone, acetophenones, 2,4-dimetyl thioxanthone, 2,4-diisopropyl thioxanthone, thioxanthones, hydroxy cyclohexyl phenyl ketone (Ciba specialty chemicals, IRGACURE® 184), 1-(4-isopropylphenyl)-2-hydroxy-2-methylpropane-1-on (Merck, Darocure® 1116), 2-hydroxy-2-methyl-1-phenylpropane-1-on (Merck, Darocure® 1173)

As the thermosetting polymer, publically known transparent thermosetting polymer can be used preferably. Such as OE6550 series (Dow Corning).

As the thermoplastic polymer, the type of thermoplastic polymer is not particularly limited. For example, natural rubber(refractive index(n)=1.52), poly-isoprene(n=1.52), poly 1,2-butadine(n=1.50), polyisobutene(n=1.51), polybutene(n=1.51), poly-2-heptyl 1,3-butadine(n=1.50), poly-2-t-butyl-1,3-butadine(n=1.51), poly-1,3-butadine(n=1.52), polyoxyethylene(n=1.46), polyoxypropylene(n=1.45), polyvinylethyl ether(n=1.45), polyvinylhexylether(n=1.46), polyvinylbutylether(n=1.46), polyethers, poly vinyl acetate(n=1.47), poly esters, such as poly vinyl propionate(n=1.47), poly urethane(n=1.5 to 1.6), ethyl celullose(n=1.48), poly vinyl chloride(n=1.54 to 1.55), poly acrylo nitrile(n=1.52), poly methacrylonitrile(n=1.52), poly-sulfone(n=1.63), poly sulfide(n=1.60), phenoxy resin(n=1.5 to 1.6), polyethylacrylate(n=1.47), poly butyl acrylate(n=1.47), poly-2-ethylhexyl acrylate(n=1.46), poly-t-butyl acrylate(n=1.46), poly-3-ethoxypropylacrylate(n=1.47), polyoxycarbonyl tetra-methacrylate(n=1.47), polymethylacrylate(n=1.47 to 1.48), polyisopropylmethacrylate(n=1.47), polydodecyl methacrylate(n=1.47), polytetradecyl methacrylate(n=1.47), poly-n-propyl methacrylate(n=1.48), poly-3,3,5-trimethylcyclohexyl methacrylate(n=1.48), polyethylmethacrylate(n=1.49), poly-2-nitro-2-methylpropylmethacrylate(n=1.49), poly-1,1-diethylpropylmethacrylate (n=1.49), poly(meth)acrylates, such as polymethylmethacrylate(n=1.49), or a combination of any of these, can be used preferably as desired.

In some embodiment of the present invention, such thermoplastic polymers can be copolymerized if necessary.

A polymer which can be copolymerized with the thermoplastic polymer described above is for example, urethane acrylate, epoxy acrylate, polyether acrylate, or, polyester acrylate (n=1.48 to 1.54) can also be employed. From the viewpoint of adhesiveness of the color conversion sheet, urethane acrylate, epoxy acrylate, and polyether acrylate are preferable.

The matrix materials and the inorganic fluorescent materials mentioned above in - **Matrix materials,** and in - **Inorganic fluorescent materials,** can be preferably used for a fabrication of the color conversion sheet (100) and the light emitting diode device (200) of the present invention.

### - Solvents

According to the present invention, the composition can further embrace a solvent.

As a solvent, wide variety of publically known solvents can be used preferably. There are no particular restrictions on the solvent as long as it can dissolve or disperse a matrix material, and inorganic fluorescent material.

In a preferred embodiment of the present invention, the solvent is selected from one or more members of the group consisting of ethylene glycol monoalkyl ethers, such as, ethylene glycol monomethyl ether, ethylene glycol monoethyl ether, ethylene glycol monopropyl ether, and ethylene glycol monobutyl ether; diethylene glycol dialkyl ethers, such as, diethylene glycol dimethyl ether, diethylene glycol diethyl ether, diethylene glycol dipropyl ether, and diethylene glycol dibutyl ether; ethylene glycol alkyl ether acetates, such as, methyl cellosolve acetate and ethyl cellosolve acetate; propylene glycol alkyl ether acetates, such as, propylene glycol monomethyl ether acetate (PGMEA), propylene glycol monoethyl ether acetate, and propylene glycol monopropyl ether acetate; aromatic hydrocarbons, such as, benzene, toluene and xylene; ketones, such as, methyl ethyl ketone, acetone, methyl amyl ketone, methyl isobutyl ketone, and cyclohexanone; alcohols, such as, ethanol, propanol, butanol, hexanol, cyclohexanol, ethylene glycol, and glycerin; esters, such as, ethyl 3-ethoxypropionate, methyl 3-methoxypropionate and ethyl lactate; and cyclic asters, such as, γ-butyrolactone. Those solvents can be used singly or in combination of two or more, and the amount thereof depends on the coating method and the thickness of the coating.

More preferably, propylene glycol alkyl ether acetates, such as, propylene glycol monomethyl ether acetate (hereafter "PGMEA"), propylene glycol monoethyl ether acetate, or propylene glycol monopropyl ether acetate and / or aromatic hydrocarbons, such as, benzene, toluene and xylene, is used.
Even more preferably, benzene, toluene, or xylene is used.

The amount of the solvent in the composition can be freely controlled according to the method of coating the composition. For example, if the composition is to be spray-coated, it can contain the solvent in an amount of 90 wt. % or more. Further, if a slit-coating method, which is often adopted in coating a large substrate, is to be carried out, the content of the solvent is normally 60 wt. % or more, preferably 70 wt. % or more.

In some embodiments of the present invention, the composition can optionally further comprise one or more of additional inorganic fluorescent materials which emits blue or red light.

As an additional inorganic fluorescent materials which emits blue or red light, any type of publically known materials, for example as described in the second chapter of Phosphor handbook (Yen, Shinoya, Yamamoto), can be used if desired.

Without wishing to be bound by theory, it is believed that the blue light especially around 450 nm wavelength light may lead better plant growth, if it is combined with emission light from the inorganic fluorescent material having the peak emission light wavelength in the range from 660 nm to 730 nm, especially the combination of the blue light around 450 nm wavelength and emission light from the inorganic fluorescent material having the peak emission light wavelength in the range from 670 nm to 700 nm is preferable for better plant growth.

Thus, more preferably, the composition can further comprise at least one blue light emitting inorganic fluorescent material having peak light emission wavelength around 450 nm, like described in the second chapter of Phosphor handbook (Yen, Shinoya, Yamamoto).

According to the present invention, in some embodiments, the composition can comprise at least one red light emitting inorganic fluorescent material and at least one blue light emitting inorganic fluorescent material in addition to the inorganic fluorescent material having the peak emission light wavelength in the range from 660 nm to 730 nm.

In another aspect, the invention relates to a color conversion sheet (100) comprising at least one inorganic fluorescent material (110) having the peak emission light wavelength in the range from 660 nm to 730 nm, and a matrix material (120).

In a preferred embodiment of the present invention, the inorganic fluorescent material (110) emits a light having peak emission light wavelength in the range from 670 nm to 700 nm.

As the inorganic fluorescent material (110), and the matrix material (120), the inorganic fluorescent material and the matrix material described in the section of **"Inorganic fluorescent materials"** and in the section of **"Matrix materials"** can be used preferably.

Thus, in some embodiments of the present invention, the inorganic fluorescent material of the color conversion sheet (sheet) can be selected from the group consisting of sulfides, thiogallates, nitrides, oxy-nitrides, silicates, metal oxides, apatites, quantum sized materials and a combination of any of these.

In a preferred embodiment of the present invention, the inorganic fluorescent material of the color conversion sheet (100) is a Cr activated metal oxide phosphor.

More preferably, the inorganic fluorescent material of the color conversion sheet (100) is selected from Cr activated metal oxide phosphors represented by following formulae (I) or (II)

AₓB_{y}O_{z}:Cr³⁺ - (I)

wherein A is a trivalent cation and is selected from the group consisting of Y, Gd, Lu, Ce, La, Tb, Sc, and Sm, B is a trivalent cation and is selected from the group consisting of Al, Ga, Lu, Sc, In; x ≧ 0; y ≧ 1; 1.5(x+y) = z;

XₐZ_{b}O_{c}:Cr³⁺ - (II)

wherein X is a divalent cation and is selected from the group consisting of Mg, Zn, Cu, Co, Ni, Fe, Ca, Sr, Ba, Mn, Ce and Sn; Y is a trivalent cation and is selected from the group consisting of Al, Ga, Lu, Sc and In; b≧ 0; a ≧ 1; (a+1.5b) = c.

More preferably, the inorganic fluorescent material of the color conversion sheet (100) is selected from Cr activated metal oxide phosphors represented by following formulae (I') or (II')

AₓB_{y}O_{z}:Cr³⁺ - (I')

wherein A is a trivalent cation and is selected from the group consisting of Y, Gd, and Zn, B is a trivalent cation and is Al or Ga; x ≧ 0; y ≧ 1; 1.5(x+y) = z;

XₐZ_{b}O_{c}:Cr³⁺ - (II')

wherein X is a divalent cation and is selected from the group consisting of Mg, Co, and Mn; Z is a trivalent cation and is selected from the group consisting of Al, or Ga; b ≧ 0; a ≧ 1; (a+1.5b) = c.

Furthermore preferably, the Cr activated metal oxide phosphor of the color conversion sheet (100) is the Cr activated metal oxide phosphor selected from the group consisting of Al₂O₃:Cr³⁺, Y₃Al₅O₁₂:Cr³⁺, MgO:Cr³⁺, ZnGa₂O₄: Cr³⁺, MgAl₂O₄: Cr³⁺, and a combination of any of these.

In some embodiments of the present invention, the matrix material of the color conversion sheet (100) can comprise a polymer selected from the group consisting of photosetting polymer, a thermosetting polymer, a thermoplastic polymer, and a combination of thereof.

In some embodiments of the present invention the color conversion sheet (100) can optionally further comprise one or more of additional inorganic fluorescent materials which emits blue or red light.

As an additional inorganic fluorescent materials which emits blue or red light, any type of publically known materials, for example as described in the second chapter of Phosphor handbook (Yen, Shinoya, Yamamoto), can be used if desired.

Without wishing to be bound by theory, it is believed that the blue light especially around 450 nm wavelength light may lead better plant growth, if it is combined with emission light from the inorganic fluorescent material having the peak emission light wavelength in the range from 660 nm to 730 nm. More preferably, it is from 660 nm to 700 nm.

Thus, more preferably, the color conversion sheet (100) further comprises at least one blue light emitting inorganic fluorescent material having peak light emission wavelength around 450 nm, like described in the second chapter of Phosphor handbook (Yen, Shinoya, Yamamoto).

According to the present invention, in some embodiments, the color conversion sheet (100) can comprise at least one red light emitting inorganic fluorescent material and at least one blue light emitting inorganic fluorescent material in addition to the inorganic fluorescent material having the peak emission light wavelength in the range from 660 nm to 730 nm.

In a preferred embodiment of the present invention, the inorganic fluorescent material can emit a light having the peak emission light wavelength in the range from 670 nm to 700 nm.

In another aspect, the present invention further relates to a light emitting diode device (200) comprising at least one inorganic fluorescent material (210) having the peak emission light wavelength in the range from 660 nm to 730 nm, a matrix material (220), and a light emitting diode element (230).

In a preferred embodiment of the present invention, the inorganic fluorescent material (210) emits a light having the peak emission light wavelength in the range from 670 nm to 700 nm.

As the inorganic fluorescent material (210), and the matrix material (220), the inorganic fluorescent material and the matrix material described in - **Inorganic fluorescent materials** and in - **Matrix materials** can be used preferably.

In some embodiment of the present invention, the inorganic fluorescent material of the light emitting diode device (200) can be selected from the group consisting of sulfides, thiogallates, nitrides, oxy-nitrides, silicates, metal oxides, apatites, and a combination of any of these.

In a preferred embodiment of the present invention, the inorganic fluorescent material of the light emitting diode device (200) is selected from Cr activated metal oxide phosphors.

More preferably, the inorganic fluorescent material of the light emitting diode device (200) is selected from Cr activated metal oxide phosphors represented by following formulae (I) or (II)

AₓB_{y}O_{z}:Cr³⁺ - (I)

wherein A is a trivalent cation and is selected from the group consisting of Y, Gd, Lu, Ce, La, Tb, Sc, and Sm, B is a trivalent cation and is selected from the group consisting of Al, Ga, Lu, Sc, In; x ≧ 0; y ≧ 1; 1.5(x+y) = z;

XₐZ_{b}O_{c}:Cr³⁺ - (II)

wherein X is a divalent cation and is selected from the group consisting of Mg, Zn, Cu, Co, Ni, Fe, Ca, Sr, Ba, Mn, Ce and Sn; Y is a trivalent cation and is selected from the group consisting of Al, Ga, Lu, Sc and In; b≧ 0; a ≧ 1; (a+1.5b) = c.

More preferably, the inorganic fluorescent material of the light emitting diode device (200) is selected from Cr activated metal oxide phosphors represented by following formulae (I') or (II')

AₓB_{y}O_{z}:Cr³⁺ - (I')

wherein A is a trivalent cation and is selected from the group consisting of Y, Gd, and Zn, B is a trivalent cation and is Al or Ga; x ≧ 0; y ≧ 1; 1.5(x+y) = z;

XₐZ_{b}O_{c}:Cr³⁺ - (II')

wherein X is a divalent cation and is selected from the group consisting of Mg, Co, and Mn; Z is a trivalent cation and is selected from the group consisting of Al, or Ga; b ≧ 0; a≧ 1; (a+1.5b) = c.

Furthermore preferably, the Cr activated metal oxide phosphor of the light emitting diode device (200) can be the Cr activated metal oxide phosphor selected from the group consisting of Al₂O₃:Cr³⁺, Y₃Al₅O₁₂:Cr³⁺, MgO:Cr³⁺, ZnGa₂O₄: Cr³⁺, MgAl₂O₄: Cr³⁺, and a combination of any of these.

In some embodiment of the present invention, the matrix material of the light emitting diode device (200) can comprise a polymer selected from the group consisting of photosetting polymer, a thermosetting polymer, a thermoplastic polymer, and a combination of thereof.

According to the present invention, preferably, the inorganic fluorescent material (210) and the matrix material can be placed on the inside of a cap (260a) of the light emitting diode device to cover the light emitting diode element (230) like described in Fig. 2.

In some embodiments of the present invention the light emitting diode device (200) can optionally further comprise one or more of additional inorganic fluorescent materials which emits blue or red light.

As an additional inorganic fluorescent materials which emits blue or red light, any type of publically known materials, for example as described in the second chapter of Phosphor handbook (Yen, Shinoya, Yamamoto), can be used if desired.

Without wishing to be bound by theory, it is believed that the blue light especially around 450 nm wavelength light may lead better plant growth, if it is combined with emission light from the inorganic fluorescent material having the peak emission light wavelength in the range from 660 nm to 730 nm, especially the combination of the blue light around 450 nm wavelength and emission light from the inorganic fluorescent material having the peak emission light wavelength in the range from 670 nm to 700 nm is preferable for better plant growth.

Thus, more preferably, the light emitting diode device (200) can further comprise at least one blue light emitting inorganic fluorescent material having peak light emission wavelength around 450 nm, like described in the second chapter of Phosphor handbook (Yen, Shinoya, Yamamoto).

According to the present invention, in some embodiments the light emitting diode device (200) can comprise at least one red light emitting inorganic fluorescent material and at least one blue light emitting inorganic fluorescent material in addition to the inorganic fluorescent material having the peak emission light wavelength in the range from 660 nm to 730 nm.

In this embodiment, more preferably, thermosetting resin can be used as a matrix material (210).

Or according to the present invention, preferably, the light emitting diode device (300) can comprises a color conversion sheet (301) comprising at least one inorganic fluorescent material (310) having the peak emission light wavelength in the range from 660 nm to 730 nm, and a matrix material (320).

Preferably, the inorganic fluorescent material (310) can emit a light having peak emission light wavelength in the range from 670 nm to 700 nm.

More preferably, the color conversion sheet (301) is placed over the light emitting diode element (330) like described in Fig. 3.

In another aspect, the present invention also relates to an optical device (300) comprising the color conversion sheet (100).

In another aspect, the present invention further relates to a use of the composition in a color conversion sheet fabrication process.

In another aspect, the invention also relates to a use of the color conversion sheet (100) in an optical device or for agriculture.

As an optical device, a light emitting diode (LED), a remote phosphor sheet, an optical communication device, an optical sensor, a solar cell.

According to the present invention, for agriculture use, the color conversion sheet can be used as greenhouse sheet, tunnel culture sheet, and mulching culture sheet.

In another aspect, the present invention furthermore relates to a use of the inorganic fluorescent material having the peak emission light wavelength in the range from 660 nm to 730 nm with a matrix material in a light emitting diode device (200).

According to the present invention, publically known film making techniques can be used to fabricate the compassion of the invention. Such as inflation, T-die coating, solution casting, calendaring method, ink jetting, slit coating, intaglio printing, relief printing, and silk screen printing.

For a molding method to provide a composition onto a light emitting diode element (230) placed onto a cap (260a), several kinds of well-known techniques can be used preferably as desired.
Such as compression molding, injection molding, blow molding, and thermo-forming method.

In another aspect of the present invention, method for preparing the color conversion sheet (100) comprises following steps (a) and (b) in this sequence;
(a) providing the composition onto a substrate, and
(b) fixing the matrix material by evaporating a solvent and / or polymerizing the composition by heat treatment, or exposing the photosensitive composition under ray of light or a combination of any of these.

In another aspect, present invention further relates to method for preparing the optical device (200), wherein the method comprises following step (A);
(A) providing the color conversion sheet (100) in an optical device.

### Definition of Terms

According to the present invention, the term "transparent" means at least around 60 % of incident visible light transmittal at the thickness used in a color conversion sheet and a light emitting diode device. Preferably, it is over 70 %, more preferably, over 75%, the most preferably, it is over 80 %.

The term "fluorescent" is defined as the physical process of light emission by a substance that has absorbed light or other electromagnetic radiation. It is a form of luminescence. In most cases, the emitted light has a longer wavelength, and therefore lower energy, than the absorbed radiation.

The term "inorganic" means any material not containing carbon atoms or any compound that containing carbon atoms ionically bound to other atoms such as carbon monoxide, carbon dioxide, carbonates, cyanides, cyanates, carbides, and thiocyanates.

The term "emission" means the emission of electromagnetic waves by electron transitions in atoms and molecules.

The term "photosensitive" means that the respective composition chemically reacts in response to suitable light irradiation. The light is usually chosen from visible or UV light. The photosensitive response includes hardening or softening of the composition, preferably hardening. Preferably the photosensitive composition is a photo-polymerizable composition.

The working examples 1 - 5 below provide descriptions of the present invention, as well as an in detail description of their fabrication.

### Working Examples

### Working Example 1:

### - Synthesis of Al₂O₃:Cr³⁺

The phosphor precursors of Al₂O₃:Cr³⁺ were synthesized by a conventional co-precipitation method. The raw materials of Aluminium Nitrate Nonahydrate and Chromium(III) nitrate nonahydrate were dissolved in deionized water with a stoichiometric molar ratio of 0.99:0.01. NH₄HCO₃ was added to the mixed chloride solution as a precipitant, and the mixture was stirred at 60 °C for 2h. The resultant solution was dried at 95 °C for 12 h, then the preparation of the precursors was completed. The obtained precursors were oxidized by calcination at 1300 °C for 3 h in air. To confirm the structure of the resultant materials, XRD measurements were performed using an X-ray diffractometer (RIGAKU RAD-RC). Photoluminescence (PL) spectra were measured using a spectrofluorometer (JASCO FP-6500) at room temperature.
The absorption peak wavelength of Al₂O₃:Cr³⁺ was 420 nm and 560 nm, the emission peak wavelength was in the range from 690 nm to 698 nm, the full width at half maximum (hereafter "FWHM") of the light emission from Al₂O₃:Cr³⁺ was in the range from 90 nm to 120 nm.

### - Composition and color conversion sheet fabrication

The composition was prepared using the obtained Al₂O₃:Cr³⁺ as an inorganic fluorescent material, ethylene vinyl acetate (EVA) as matrix polymer, and toluene as a solvent.
Then, the composition was used in a color conversion sheet fabrication process to obtain a color conversion sheet for an effective plant growth. For the sheet fabrication, doctor blade coating method and a bar coater (Kodaira YOA-B type) were applied.
More specifically, Al₂O₃:Cr³⁺ and ethylene vinyl acetate (EVA) were added into the toluene. Then, the obtained solution was heated up to 90 °C, and then mixed in a closed container by a planetary centrifugal mixer at 90 °C for 30 minutes to obtain a composition of the present invention. A glass substrate was cleaned by sonicating in acetone and isopropanol, respectively. The substrate was then treated with UV/ ozone.

The resulting solution was coated onto the glass substrate by doctor blade coating method, then dried at 90 °C for 30 minutes in air condition. After drying step, a color conversion sheet having 100 µm thickness was formed on the glass substrate, and then it was peeled off from the glass substrate. Finally, the color conversion sheet having 100 µm thickness was fabricated.

### Comparative Example 1:

A composition and a color conversion sheet as a comparative example was prepared and fabricated in the same manner as described in the working example 1 except for Lumogen ® F Red305 (from BASF) was used instead of Al2O3:Cr³⁺.

### Working Example 2:

The obtained color conversion sheet from above-described examples were arranged to cover sprouts of brassica campestris planted in flowerpots and exposed to sunlight for 20 days.

The measurement was carried out by measuring an average height of each three brassica campestris grew with the color conversion sheet comprising Al₂O₃:Cr³⁺ or with the color conversion sheet including Lumogen ® F Red305.

The average height of brassica campestris grew with the color conversion sheet comprising Al₂O₃:Cr³⁺ was 6 % higher than the average height of brassica campestris grew with the color conversion sheet Lumogen ® F Red305.

### Working example 3:

### - Fabrication of a light emitting diode device (LED)

First, a color conversion sheet was prepared in the same way as described in working example 1, then it was cut out to fit and attach it to the light emission side of InGaN-based UV LED (405 nm). Then, the light emitting diode device (hereafter "the LED device") was fabricated.

### Working example 4:

The Al₂O₃:Cr³⁺ phosphor from Example 1 was mixed in a tumble mixer with OE 6550 (Dow Corning). The final concentration of the phosphor in the silicone is 8 mol%. The slurry was applied to an InGaN-based LED chip emitting a wavelength of 405 nm. Then it was heated at 150°C for 1 hour using an oven. After packaging process, 2^{nd} light emitting diode device (LED) was fabricated.

### Working example 5:

The obtained LED device from working example 3 was arranged together with normal white LED lamp to the position to expose sprouts of Rucola planted in flowerpots.
Light irradiation 800 µW/cm² by the obtained light emitting diode device and normal white LED lamp was carried out with for 16 days.

As a comparison, sprouts of Rucola planted in flowerpots was irradiated in the same manner as described in above except for only one normal white LED lamp was used without the LED device from working example 3.

The measurement was carried out by measuring an average height of three Rucolas grew with the LED device comprising Al₂O₃:Cr³⁺ and the white LED lamp or with only the white LED lamp.

As a results the average height of Rucolas grew with the LED device comprising Al₂O₃:Cr³⁺ and the white LED lamp was 10 % higher than the average height of Rucolas grew with the white LED lamp only.

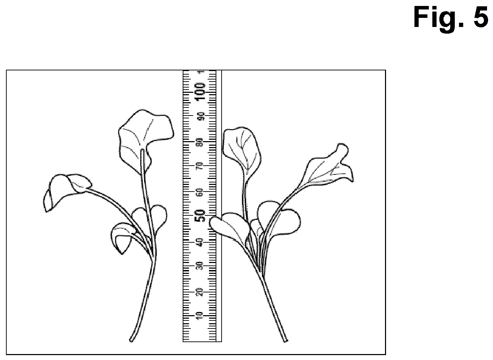

Fig. 4 and Fig. 5 show the difference of Rucola (left side) grew with the LED device with Al₂O₃:Cr³⁺ and the white LED lamp and Rucola (right side) grew with the white LED lamp only.

## Claims

1. A composition comprising at least one inorganic fluorescent material having a peak emission light wavelength in the range from 660 nm to 730 nm, and a matrix material, wherein said matrix material further comprises one or more of bromine-containing monomers, sulfer containing monomers.

2. The composition according to claim 1, wherein at least one inorganic fluorescent material is selected from the group consisting of sulfides, thiogallates, nitrides, oxy-nitrides, silicates, metal oxides, apatites, quantum sized materials, and a combination of any of these.

3. The composition according to claim 1 or 2, wherein the inorganic fluorescent material is selected from Cr activated metal oxide phosphors.

4. The composition according to any one of claims 1 to 3, wherein the matrix material comprises a polymer selected from the group consisting of photosetting polymer, a thermosetting polymer, a thermoplastic polymer, and a combination of any of these.

5. A color conversion sheet (100) comprising at least one inorganic fluorescent material (110) having the peak emission light wavelength in the range from 660 nm to 730 nm, and a matrix material (120), wherein said matrix material further comprises one or more of bromine-containing monomers, sulfer containing monomers.

6. The color conversion sheet (100) according to claim 5, wherein the inorganic fluorescent material is selected from the group consisting of sulfides, thiogallates, nitrides, oxy-nitrides, silicates, metal oxides, apatites, and a combination of any of these.

7. The color conversion sheet (100) according to claim 5 or 6, wherein the inorganic fluorescent material is selected from Cr activated metal oxide phosphors.

8. The color conversion sheet (100) according to any one of claims 5 to 7, wherein the matrix material comprises a polymer selected from the group consisting of photosetting polymer, a thermosetting polymer, a thermoplastic polymer, and a combination of thereof.

9. A light emitting diode device (200) comprising at least one inorganic fluorescent material (210) having the peak emission light wavelength in the range from 660 nm to 730 nm, a matrix material (220), and a light emitting diode element (230), wherein said matrix material further comprises one or more of bromine-containing monomers, sulfer containing monomers.

10. The light emitting diode device (200) according to claim 9, wherein the inorganic fluorescent material is selected from the group consisting of sulfides, thiogallates, nitrides, oxy-nitrides, silicates, metal oxides, apatites, quantum sized materials and a combination of any of these.

11. The light emitting diode device (200) according to claim 9 or 10, wherein the matrix material comprises a polymer selected from the group consisting of photosetting polymer, a thermosetting polymer, a thermoplastic polymer, and a combination of thereof.

12. An optical device (300) comprising the color conversion sheet (100) according to any one of claims 5 to 8.

13. Use of the composition according to any one of claims 1 to 4 in a color conversion sheet fabrication process.

14. Use of the color conversion sheet (100) according to any one of claims 5 to 8, in an optical device.

15. Use of the color conversion sheet (100) according to any one of claims 5 to 8 for agriculture.

16. Method for preparing the color conversion sheet (100), wherein the method comprises following steps
(a) and
(b) in this sequence;
(c) providing the composition according to any one of claims 1 to 4, onto a substrate, and
(d) fixing the matrix material by evaporating a solvent and / or polymerizing the composition by heat treatment or exposing the photosensitive composition under ray of light or a combination of any of these.

17. Method for preparing the optical device (200), wherein the method comprises following step (A);
(A) providing the color conversion sheet (100) according to any one of claims 5 to 8, in an optical device.
